# DEMANDE DE BREVET EUROPEEN

(11) **EP 0 881 693 A1**
(43) Date de publication de la demande: **02.12.1998**
(21) Numéro de dépôt: 98410059.4
(22) Date de dépôt: 25.05.1998
(51) Int. Cl.: H01L 29/866

(54) **Référence de tension dans un circuit intégré**

(30) Priorité: 30.05.1997 FR 9706907
(71) Demandeur: SGS-THOMSON MICROELECTRONICS S.A., 94250 Gentilly (FR)
(72) Inventeur: Jimenez, Jean, 38920 Crolles (FR)
(74) Mandataire: de Beaumont, Michel

(57) **Abrégé**

L'invention concerne une référence de tension dans un circuit intégré, constituée d'un transistor bipolaire NPN dont la base n'est pas connectée et dont l'émetteur (E) correspond à une anode et le collecteur (C) à une cathode.

## Description

La présente invention concerne le domaine des circuits intégrés et plus particulièrement la formation d'une référence de tension dans un circuit intégré.

Une référence de tension est un dispositif qui présente une tension sensiblement constante à ses bornes quand il est parcouru par un courant situé dans une certaine plage de valeur.

Une caractéristique recherchée pour une référence de tension est tout d'abord que la tension à ses bornes reste aussi constante que possible quand le courant qui traverse la source de tension varie dans une plage relativement importante.

Une autre caractéristique recherchée est que cette tension soit stable dans le temps et en température.

Un premier type classique de référence de tension est une référence de tension de type dite à bande interdite (BAND GAP) qui constitue une référence de tension particulièrement précise et stable mais qui utilise un grand nombre de composants et qui occupe donc une surface de circuit intégré non-négligeable. Ainsi, de telles sources de tension ne sont pas adaptées en particulier à constituer des dispositifs de protection pour limiter à une tension déterminée la tension entre deux bornes d'un dispositif à protéger, par exemple entre grille et source d'un transistor MOS.

Une autre référence de tension connue est la diode Zener. Cette référence de tension présente l'avantage d'être relativement simple à réaliser dans un circuit intégré et d'y occuper une faible surface. Une diode Zener peut simplement être utilisée comme source de tension ou bien comme dispositif de protection à une tension donnée. Toutefois, ce dispositif présente l'inconvénient d'être peu stable dans le temps, c'est-à-dire que si l'on fait circuler dans une diode Zener son courant nominal pendant une longue durée, la tension à ses bornes dérive. Par exemple, pour une diode Zener classique réalisée en surface d'un circuit intégré, la variation de tension nominale est couramment de l'ordre de 0,06 volt par heure et peut atteindre une valeur de l'ordre du volt au bout de 1000 heures d'utilsation. De plus, une diode Zener de circuit intégré présente une tension constante seulement sur une faible plage de courant.

Ainsi, un objet de la présente invention est de prévoir une référence de tension réalisable dans un circuit intégré et présentant la simplicité d'une diode Zener et sa faible occupation de surface mais dont la tension soit constante sur une plage de courant plus importante.

Un autre objet de la présente invention est de prévoir une référence de tension qui soit stable dans le temps.

Un autre objet de la présente invention est de prévoir une référence de tension qui soit réalisable aussi simplement dans un circuit intégré bipolaire que dans un circuit intégré de type MOS.

Pour atteindre ces objets, la présente invention prévoit une référence de tension dans un circuit intégré, constituée d'un transistor bipolaire NPN dont la base n'est pas connectée et dont l'émetteur correspond à une anode et le collecteur à une cathode.

Selon un mode de réalisation de la présente invention, le transistor est un transistor bipolaire NPN d'un circuit intégré de type bipolaire.

Selon un mode de réalisation de la présente invention, le transistor bipolaire NPN est formé dans un caisson N d'un circuit intégré de type MOS, l'émetteur correspondant à une region de drain-source d'un transistor MOS à canal N formée dans une région correspondant à une région de drain-source d'un transistor MOS à canal P.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente le schéma équivalent d'une référence de tension selon la présente invention ;
la figure 2 représente une référence de tension selon la présente invention constituée d'un transistor bipolaire de type NPN dans un circuit intégré de type bipolaire ;
la figure 3 représente une référence de tension selon la présente invention constituée d'un transistor bipolaire de type NPN dans un circuit intégré de type MOS ;
la figure 4 représente la caractéristique courant-tension d'une référence de tension selon la présente invention, et, à titre de comparaison la caractéristique courant-tension d'une diode Zener usuelle de circuit intégré, le courant étant en échelle logarithmique ;
la figure 5 représente la caractéristique courant-tension d'une référence de tension selon la présente invention, le courant étant en échelle linéaire ; et
la figure 6 représente très schématiquement la caractéristique de variation de tension dans le temps d'une source de tension selon la présente invention comparée à une diode Zener.

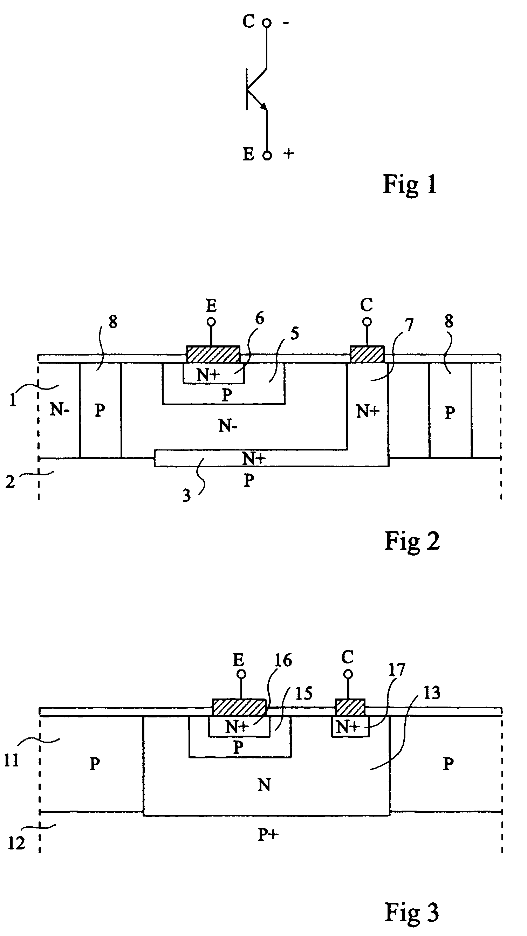

Comme le représente schématiquement la figure 1, la présente invention prévoit d'utiliser en dipôle un transistor bipolaire de type NPN connecté entre son collecteur et son émetteur, sa base n'étant pas connectée (étant maintenue flottante). La borne d'émetteur E correspond à la borne d'anode (+) et la borne de collecteur C correspond à la borne de cathode (-) du dipôle. On montrera ci-après qu'un tel dispositif peut être utilisé de la même façon qu'une diode Zener mais présente l'avantage d'une meilleure stabilité dans le temps et d'une plus faible dispersion de tension sur une large plage de courant.

La figure 2 représente un premier mode de réalisation de la présente invention. Cette figure représente un transistor bipolaire NPN classique forme dans un circuit intégré bipolaire. Le transistor bipolaire correspond à une technologie classique dans laquelle une couche épitaxiée 1 de type N faiblement dopée est formée sur un substrat 2 de silicium de type P. A l'emplacement du transistor est formée une couche enterrée 3, avant la croissance de la couche épitaxiée. Le transistor bipolaire comprend une région de base 5 de type P formée dans la couche épitaxiée, une région d'émetteur 6 de type N formée dans la région de base 5 et, une région 7 de type N⁺ servant de contact de collecteur. De préférence, cette région se prolonge en un puits collecteur pour entrer en contact avec la couche enterrée 3. De préférence, pour assurer son isolement, le composant est entouré d'un mur d'isolement 8 de type P qui traverse la couche épitaxiée 1.

Selon la présente invention, on utilise ce dispositif comme dipôle de référence de tension, c'est-à-dire que l'on prévoit seulement une métallisation d'émetteur E sur la région d'émetteur 6 et une métallisation de collecteur C sur la région de prise de contact de collecteur 7.

La figure 3 représente un mode de réalisation de la présente invention réalisée dans un circuit intégré de type CMOS, c'est-à-dire un circuit intégré dans lequel on prévoit de former essentiellement des transistors MOS à canal N et des transistors MOS à canal P. On considère par exemple en figure 3 une filière dans laquelle une couche épitaxiée 11 de type P est formée sur un substrat 12 de type P⁺. Dans cette technologie, des transistors MOS à canal N sont formés directement dans la couche épitaxiée 11 et des transistors MOS à canal P sont formés dans des caissons de type N formés dans cette couche épitaxiée. La référence 13 indique un exemple d'un tel caisson dans lequel est réalisé un composant selon la présente invention. Ce composant comprend une région 15 de type P formée dans le caisson 13. Cette région de type P correspond par exemple aux implantations-diffusions de drains et de sources des transistors à canal P. Dans la région 15 est formée une région 16 de type N. Cette région 16 correspond par exemple aux implantations-diffusions de drains et de sources des transistors MOS à canal N. En outre, on forme une région de reprise de contact de collecteur 17 en même temps que la région 16. On obtient donc un transistor NPN dont l'émetteur correspond à la région 16, la base à la région 15 et le collecteur à la région 17. Selon l'invention, on forme seulement une métallisation d'émetteur E et une métallisation de collecteur C. Le transistor NPN résultant aura bien entendu un faible gain puisque la région 15 est relativement fortement dopée mais convient parfaitement à la formation d'une référence de tension selon l'invention.

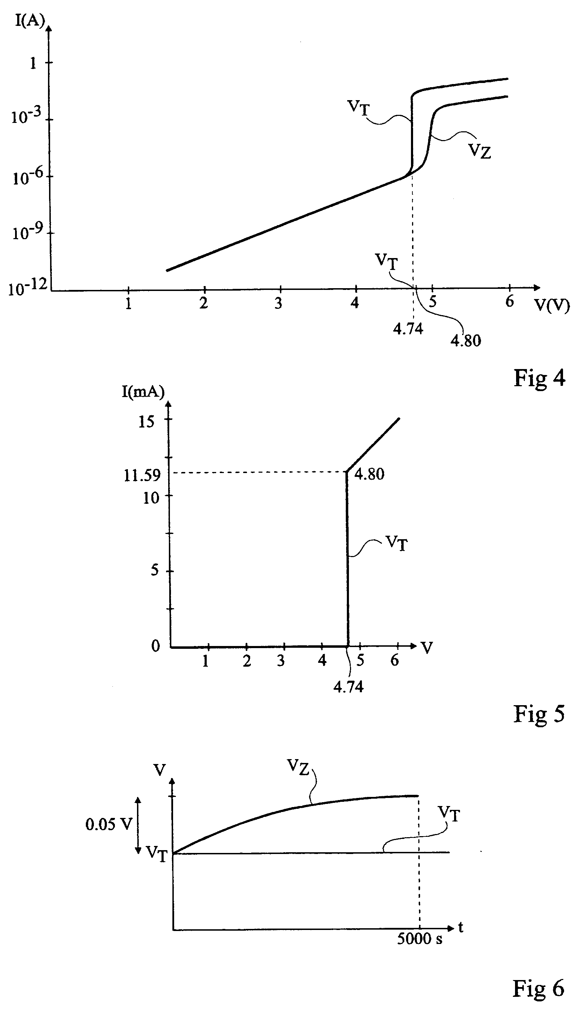

La demanderesse a étudié la caractéristique courant-tension V_{T} du dipôle des figures 1, 2 et 3. Les figures 4 et 5 représentent la caractéristique d'un tel dipôle dans le cas particulier de la figure 2. Les figures 4 et 5 représentent la même courbe, la différence étant qu'en figure 4 le courant est tracé en coordonnées logarithmiques et qu'en figure 5 le courant est tracé en coordonnées linéaires.

Plus particulièrement, dans un exemple de réalisation, les caractéristiques du dispositif de la figure 2 étaient les suivantes :
- pour la région 6 de type N⁺ : profondeur de jonction xⱼ = 0,25 µm, concentration en surface Cₛ = 1 à 3 10²⁰ at./cm³, résistance par carré = 20 à 50 ohms ;
- pour la région 5 de type P, profondeur de jonction xⱼ = 0,4 à 0,5 µm, concentration à la jonction avec la région 6 Cₓⱼ = 2 à 7 10¹⁷ at./cm³, résistance par carré = 600 à 1000 ohms, résistance par carré sous la région 6 = 5 à 12 kohms.

On observe que la tension V_{T} croît sensiblement régulièrement avec le courant jusqu'à atteindre une valeur de seuil, égale à 4,74 volts dans l'exemple représenté, tant que le courant reste inférieur à 1 microampère. Ensuite, la tension entre les bornes E et C reste sensiblement constante tandis que le courant croît d'une valeur de l'ordre de 1 µA à une valeur de l'ordre de 10 mA. Plus particulièrement, on a mesuré une tension de 4,80 volts pour 11,6 mA. Enfin, pour de plus fortes valeurs de courant, la tension varie en fonction de l'impédance du circuit dans lequel est inséré le composant selon l'invention.

On notera donc une très faible dispersion de tension (de l'ordre de 1 %) pour des valeurs de courant qui croissent dans un rapport de 1 à 10 000. On a donc là une source de tension particulièrement stable et indépendante du courant qui la traverse.

On observe des résultats similaires quelle que soit la structure utilisée, notamment dans le cas d'une structure du type de celle de la figure 3. On notera d'ailleurs que ces structures sont susceptibles de très nombreuses variantes, et peuvent être réalisées dans de très nombreuses filières technologiques, par exemple, dans le cas de la figure 3, l'invention fonctionne également quand la couche épitaxiée 11 est formée sur un substrat de type N. Elle fonctionne également que l'on prévoit ou non une couche enterrée et, comme on l'a indiqué précédemment que l'on prévoit ou non un puits collecteur. L'avantage de la prévision du puits collecteur et de la couche enterrée est que l'on augmente la plage dynamique de fonctionnement.

La figure 4 représente également à titre de comparaison la caractéristique d'une diode Zener équivalente constituée d'une région d'un premier type de conductivité formée dans la région du type de conductivité opposé à la surface d'un circuit intégré.

On notera que la zone de stabilisation de la diode Zener est inférieure à trois décades (de 1 µm à moins de 1 mA) et que, sur cette zone, la tension varie d'environ 0,25 V. La dispersion de tension est donc de l'ordre de 5 %, c'est-à-dire nettement plus grande qu'avec l'invention et sur une plus petite plage.

Par ailleurs, la figure 6 représente la variation de tension en fonction du temps. Avec un dispositif selon la présente invention, cette variation est très faible, par exemple sur une durée de 5000 secondes, pour une tension nominale de l'ordre de 5 volts, on a observé une variation de tension inférieure à la précision de l'appareil de mesure qui était de 5 mV alors que, avec une diode Zener, la caractéristique VZ présente une variation de sensiblement de 50 mV au bout de 5000 secondes de fonctionnement. En outre, si le fonctionnement de la diode Zener est poursuivi pendant par exemple un millier d'heures, on observe une variation de tension de l'ordre du volt.

Ainsi, le dispositif selon la présente invention atteint les objets recherchés de fournir une source de tension stable sur une large plage de courant et de fournir une tension stable en fonction du temps. En outre, la stabilité en température est au moins égale à celle d'une diode Zener (de l'ordre de + 1 mV/°C).

La présente invention se prête tout particulièrement à la réalisation de références de tension dans des circuits intégrés de très petites dimensions, par exemple submicroniques.

Bien entendu, la présente invention est susceptible de nombreuses variantes qui apparaîtront à l'homme de l'art.

## Revendications

1. Référence de tension dans un circuit intégré, caractérisée en ce qu'elle est constituée d'un transistor bipolaire NPN dont la base n'est pas connectée et dont l'émetteur (E) correspond à une anode et le collecteur (C) à une cathode.

2. Référence de tension selon la revendication 1, caractérisée en ce que ledit transistor est un transistor bipolaire NPN d'un circuit intégré de type bipolaire.

3. Référence de tension selon la revendication 1, caractérisée en ce que ledit transistor bipolaire NPN est formé dans un caisson N d'un circuit intégré de type MOS, l'émetteur correspondant à une région (16) de drain-source d'un transistor MOS à canal N formée dans une région (15) correspondant à une région de drain-source d'un transistor MOS à canal P.
